# EUROPEAN PATENT APPLICATION

(11) **EP 3 582 391 A1**
(43) Date of publication of application: **18.12.2019**
(21) Application number: 18751617.4
(22) Date of filing: 07.02.2018
(51) Int. Cl.: H02P 29/024, G06F 12/06

(54) **MOTOR-RELATED INFORMATION PROCESSING CIRCUIT, MOTOR-RELATED INFORMATION PROCESSING METHOD AND MOTOR MODULE**

(30) Priority: 08.02.2017 JP 2017021133
(71) Applicant: Nidec Corporation, Kyoto-shi, Kyoto 601-8205 (JP)
(72) Inventor: KOGA, Kazuyoshi, Kyoto-shi Kyoto 601-8205 (JP)
(74) Representative: Zimmermann, Tankred Klaus
(86) International application number: PCT/JP2018/004117
(87) International publication number: WO 2018/147304

(57) **Abstract**

[Object] To provide a technique capable of reliably writing information on an operational state of a motor to a non-volatile memory while using an inexpensive microcomputer.

[Solution] A motor-related information processing circuit includes: an acquisition unit configured to acquire motor-related information regarding an operational state of a motor when the motor is driven; a first writing unit configured to write the motor-related information to a volatile memory after the motor-related information is acquired; and a second writing unit configured to write the motor-related information stored in the volatile memory to a non-volatile memory when driving of the motor is stopped.

## Description

### Technical Field

The present invention relates to a motor-related information processing circuit, a motor-related information processing method, and a motor module.

### Background Art

A factory or a plant in which a working robot is installed is generally provided with a motor module including a motor for operating the robot, and a control apparatus for controlling the motor module. When the motor module is incorporated into the robot, it may be difficult for a user to frequently grasp the state of the motor module depending on the configuration of the robot or the position of the motor module. Therefore, to enable the user to grasp the operational state of the motor module, the motor module may transmit various types of information to the control apparatus that is operated by the user (see, e.g., PTL 1).

### Citation List

### Patent Literature

PTL 1: International Publication No. 2013/136627

### Summary of Invention

### Technical Problem

However, in the technique described above, the user cannot grasp the state of the motor module when a transmission unit of the motor module for transmitting information has failed or when a communication error has occurred during transmission. If the motor module is provided with a non-volatile memory and various types of information are stored in such a memory, the user can check the state of the motor module by accessing the non-volatile memory as appropriate. However, a processing load is generally placed on a microcomputer when the microcomputer writes information to the non-volatile memory. Therefore, for example, to cause a microcomputer for controlling the motor module to execute a writing process, an expensive microcomputer having high processing capability is required.

The present invention has been made in view of the above problems and is to provide a technique capable of reliably writing information on an operational state of a motor to a non-volatile memory while using an inexpensive microcomputer.

### Solution to Problem

A motor-related information processing circuit of the present invention to solve the above problemsincludes: an acquisition unit configured to acquire motor-related information regarding an operational state of a motor when the motor is driven; a first writing unit configured to write the motor-related information to a volatile memory after the motor-related information is acquired; and a second writing unit configured to write the motor-related information stored in the volatile memory to a non-volatile memory when driving of the motor is stopped.

### Advantageous Effects of Invention

According to the present invention, it is possible to provide a technique capable of reliably writing information on an operational state of a motor to a non-volatile memory while using an inexpensive microcomputer.

### Brief Description of Drawings

[Fig. 1] Fig. 1 is a diagram illustrating a configuration of a robot control system 10.
[Fig. 2] Fig. 2 is a diagram illustrating a configuration of a motor module 23.
[Fig. 3] Fig. 3 is a diagram illustrating functional blocks implemented in a microcomputer 62.
[Fig. 4] Fig. 4 is a flowchart illustrating an example of processes executed by the microcomputer 62.
[Fig. 5] Fig. 5 is a flowchart illustrating an example of processes executed by the microcomputer 62.

### Description of Embodiments

### Configuration of Robot Control System 10

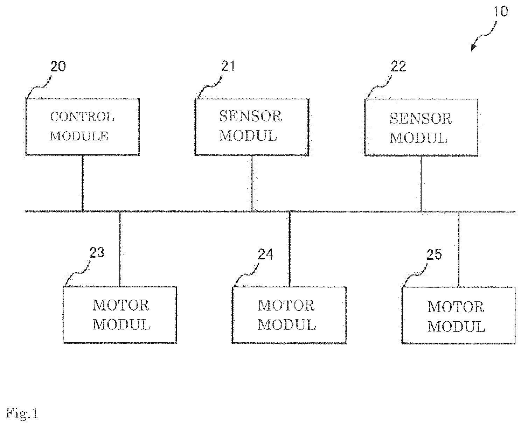

An embodiment of the present invention is described below in detail using the drawings. Fig. 1 illustrates a configuration of a robot control system 10. The robot control system 10 is a system for controlling motions of an arm-type robot X (not shown) installed in a factory and includes a control module 20, sensor modules 21 and 22, and motor modules 23 to 25.

The control module 20 (control apparatus) is an apparatus for controlling the overall robot control system 10 and controls the operation of the motor modules 23 to 25 in accordance with the result of a user operation and output from the sensor modules 21 and 22.

The sensor module 21 is, for example, an apparatus including a distance sensor for measuring the distance to a work object of the arm-type robot X and transmits a measurement result to the control module 20.

The sensor module 22 is, for example, an apparatus including an infrared sensor for detecting whether a person is present within a working area of the arm-type robot X and transmits a detection result to the control module 20.

The motor module 23 is an apparatus for controlling a motor for rotating a predetermined joint J1 of the arm-type robot X. The motor modules 24 and 25 also control motors for rotating predetermined joints J2 and J3, respectively, of the arm-type robot X in a similar manner to the motor module 23. Note that although the sensor module 21, the motor module 23, and the like in Fig. 1 are connected to the control module 20 via a communication line, those modules may be connected wirelessly.

### Configuration of Motor Module 23

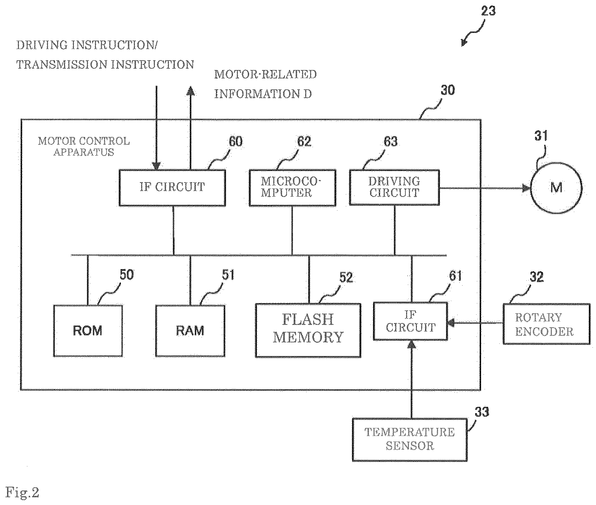

As illustrated in Fig. 2, the motor module 23 includes a motor control apparatus 30, a motor 31, a rotary encoder 32, and a temperature sensor 33. The motor module 23 includes the motor 31, a driving circuit 63, and a motor-related information processing circuit.

The motor control apparatus 30 is an apparatus for driving the motor 31 in accordance with a driving instruction from the control module 20. Here, current that is supplied from the motor control apparatus 30 to the motor 31 and flows into the motor 31 is referred to as driving current Id. The driving instruction is an instruction for specifying the rotational position, the rotational speed, and the torque of the motor 31. Note that details of the motor control apparatus 30 are described later.

The motor 31 is, for example, an AC (alternating current) motor and rotates an arm portion of the arm-type robot X.

The rotary encoder 32 outputs a signal indicating the rotational position of a rotor (not shown) in the motor 31, and a signal indicating the rotational speed of the motor 31.

The temperature sensor 33 is a sensor attached at a predetermined position of the motor module 23 to detect a temperature Tm of the motor 31 and outputs a signal indicating the temperature Tm. Note that the temperature Tm rises as the driving current Id increases.

The motor control apparatus 30 includes a ROM (read-only memory) 50, a RAM (random access memory) 51, a flash memory 52, IF (interface) circuits 60 and 61, a microcomputer 62, and a driving circuit 63.

The ROM 50 is an area of non-volatile storage, and a program executed by the microcomputer 62 and various data are stored in the ROM 50.

The RAM 51 (volatile memory) is used as a temporary storage area for a program, data, and the like.

For example, motor-related information D regarding an operational state of the motor 31 and various data are stored in the flash memory 52 (non-volatile memory). Here, the motor-related information D includes, for example, information on the average, variance, minimum, and maximum in a predetermined time period of each of the driving current Id and the torque T and the temperature Tm of the motor 31 and information indicating a driving time of the motor 31. Note that the motor-related information D may be information obtained using a driving instruction described later or information obtained using control information. Therefore, for example, the user can refer to the motor-related information D to obtain knowledge about the reliability of the motor 31, the necessity of maintenance, and the like without, for example, directly observing the motor 31.

The IF circuit 60 receives and transmits various types of information such as a driving instruction and the motor-related information D between the control module 20 and the motor control apparatus 30.

The IF circuit 61 transmits output from the rotary encoder 32 and output from the temperature sensor 33 to the microcomputer 62.

The microcomputer 62 (motor-related information processing circuit) controls the overall motor control apparatus 30 by executing a program stored in the ROM 50. Functional blocks implemented in the microcomputer 62 are described later.

The driving circuit 63 is a circuit for driving the motor 31 according to a driving signal Sd from the microcomputer 62 and includes, for example, a pre-driver and an H bridge circuit (not shown). Note that the driving current Id becomes zero when the driving circuit 63 stops the driving of the motor 31. But here, leakage current which flows into the motor 31 when the driving of the motor 31 is stopped is ignored. A state in which the driving of the motor 31 is stopped is referred to as an "idle state" in this embodiment.

Since the configuration of the motor module 24 and the configuration of the motor module 25 are also similar to that of the motor module 23, detailed description of the motor modules 24 and 25 is omitted.

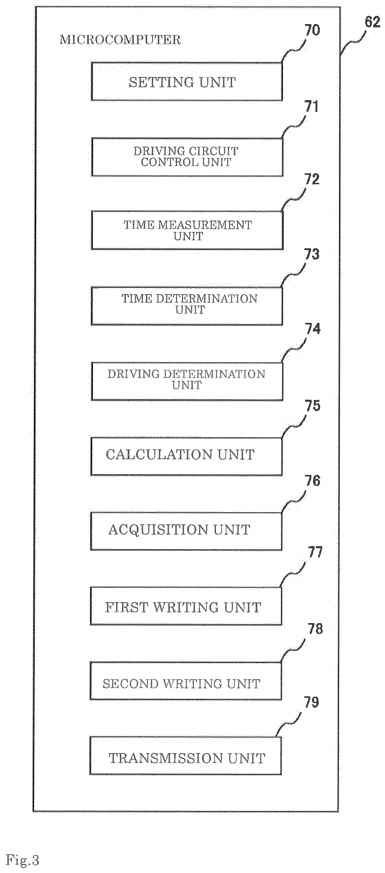

Functional Blocks Implemented in Microcomputer 62 Fig. 3 is a diagram illustrating functional blocks implemented in the microcomputer 62 by the microcomputer 62 executing a predetermined program. The motor-related information processing circuit includes functional blocks of a setting unit 70, a driving circuit control unit 71, a time measurement unit 72, a time determination unit 73, a driving determination unit 74, a calculation unit 75, an acquisition unit 76, a first writing unit 77, a second writing unit 78, and a transmission unit 79.

When receiving a driving instruction for the motor 31, the setting unit 70 erases information indicating a past driving time of the motor 31 stored in the RAM 51 and specifies a storage area in the RAM 51 where the motor-related information D is to be stored.

The driving circuit control unit 71 is a functional block for servo-controlling the motor 31 together with the driving circuit 63. Specifically, the driving circuit control unit 71 outputs the driving signal Sd to the driving circuit 63 so that the rotational position, the rotational speed, and the torque of the motor 31 may reach a target state specified by the driving instruction from the control module 20. Output from the temperature sensor 33 is input to the driving circuit control unit 71 in addition to various types of information (the driving current Id and output of the rotary encoder 32) for realizing servo control. The driving circuit control unit 71 computes the driving signal Sd by using a control algorithm such as a feedback loop based on the driving instruction and the various types of information. For example, when the temperature Tm exceeds a predetermined temperature, the driving circuit control unit 71 stops outputting the driving signal Sd to protect the motor 31. At this time, the motor 31 enters the idle state. For example, when a driving instruction for performing a series of motions that is output from the control module 20 has ended, the driving circuit control unit 71 stops outputting the driving signal Sd because no driving instruction is input. At this time, the motor 31 enters the idle state. Note that information for controlling the motor 31 (the driving current Id, output of the rotary encoder 32, and output of the temperature sensor 33) is referred to as "control information".

When the motor 31 is driven, the time measurement unit 72 measures a time from the start of driving. While the motor 31 is being driven, the time determination unit 73 determines whether a predetermined time has elapsed since a predetermined timing.

The driving determination unit 74 determines whether or not the motor 31 is driven, that is, whether the motor 31 is in the driven state or in the idle state.

The calculation unit 75 calculates various types of information on the driving current Id and the torque T and the temperature Tm of the motor 31 (the average, variance, minimum, and maximum in a predetermined time period). Specifically, the calculation unit 75 calculates the average and the like of each of the driving current Id and the torque T in accordance with the driving current Id. That is, the calculation unit 75 performs a predetermined calculation process on the driving current Id of the motor. The calculation unit 75 may calculate the average and the like with respect to the temperature Tm in accordance with output from the temperature sensor 33.

The acquisition unit 76 acquires, as the motor-related information D, the driving time of the motor 31 measured by the time measurement unit 72 and a calculation result in the calculation unit 75.

The first writing unit 77 writes the motor-related information D acquired by the acquisition unit 76 to the RAM 51.

The second writing unit 78 writes the motor-related information D stored in the RAM 51 to the flash memory 52.

The transmission unit 79 transmits the motor-related information D stored in the flash memory 52 to the control module 20 in accordance with a transmission instruction from the control module 20. That is, in accordance with the transmission instruction from the control apparatus for controlling the motor-related information processing circuit, the transmission unit 79 transmits, to the control apparatus, the motor-related information D stored in the non-volatile memory.

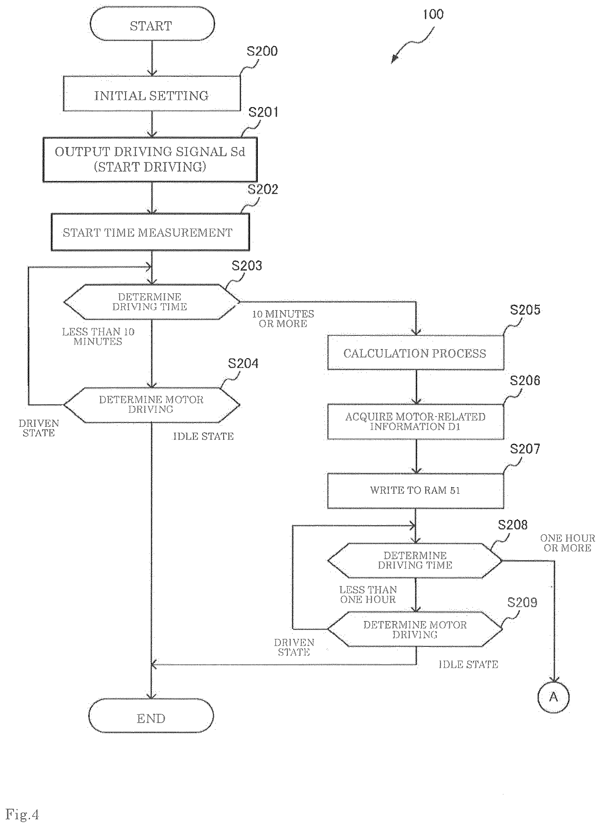

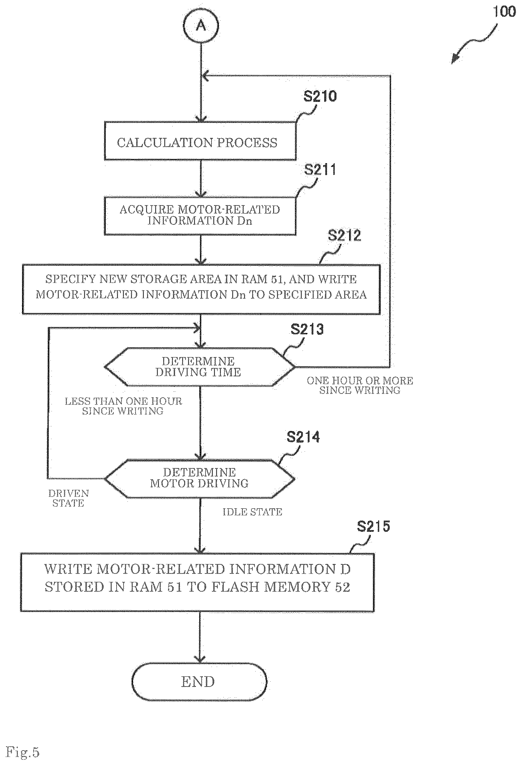

Example of Processes Executed by Microcomputer 62 Hereinafter, a series of processes 100 executed by the microcomputer 62 when the motor-related information D is written to the flash memory 52 is described with reference to Figs. 4 and 5.

It is assumed here that a predetermined driving instruction is output from the control module 20 to the motor control apparatus 30 so that the arm of the arm-type robot X (not shown) may perform a predetermined motion.

First, when receiving the driving instruction from the control module 20, the setting unit 70 performs initial setting of the RAM 51 (S200). Specifically, the setting unit 70 erases a past driving time of the motor 31 stored in the RAM 51 and specifies an area in the RAM 51 where the motor-related information D is to be stored.

The driving circuit control unit 71 outputs the driving signal Sd for placing the motor 31 into a target state in accordance with the driving instruction and the control information described above (S201). As a result, the driving of the motor 31 is started. When the driving of the motor 31 is started, the time measurement unit 72 measures a time from the start of driving (S202). The time determination unit 73 determines whether a driving time of 10 minutes or more has elapsed since the start of driving of the motor 31 (S203). Here, "10 minutes" from the start of driving of the motor 31 is an example of a time period in which the driving time of the motor 31 is short and in which there is almost no change in the state of the motor 31. That is, the driving time of 10 minutes in the time determination unit 73 may be changed as appropriate depending on applications using the invention of the present disclosure.

When less than 10 minutes has elapsed since the start of driving of the motor 31 (S203: LESS THAN 10 MINUTES), the driving determination unit 74 determines whether the motor 31 is in the driven state (S204). When it is determined in the process S204 that the motor 31 is in the idle state (S204: IDLE STATE), the processes 100 end. Therefore, when the motor 31 enters the idle state less than 10 minutes after the start of driving of the motor 31, that is, in such a case that the driving time of the motor 31 is short and that there is almost no change in the state of the motor 31, the processes 100 end without the motor-related information D being acquired.

On the other hand, when it is determined in the process S204 that the motor 31 is in the driven state (S204: DRIVEN STATE), the process S203 described above is executed. When 10 minutes or more has elapsed since the start of driving of the motor 31 (S203: 10 MINUTES OR MORE), that is, when a time period in which a certain load is placed on the motor 31 has elapsed since the start of driving, the calculation unit 75 calculates the average and the like with respect to each of the driving current Id, the torque T, and the temperature Tm (S205). Note that the average, variance, minimum, and maximum of each of the driving current Id and the like calculated in the process S205 are values in a period of 10 minutes from the start of driving of the motor 31.

The acquisition unit 76 acquires information indicating a calculation result in a period of 10 minutes from the start of driving and the driving time (10 minutes) from the start of driving of the motor 31 as motor-related information D1 (S206). Note that the motor-related information in a certain time period is referred to here as "motor-related information Dn", and the motor-related information D is defined to include all the motor-related information D1 to Dn in each time period acquired by the acquisition unit 76.

After the acquisition unit 76 acquires the motor-related information D1, the first writing unit 77 writes the motor-related information D1 to the RAM 51 (S207). The time determination unit 73 determines whether a driving time of one hour or more has elapsed since the start of driving (S208). Note that one hour (the predetermined time period) is an example of a time period suitable for observing the state of the motor 31 when the motor 31 is driven continuously.

When less than one hour has elapsed since the start of driving (S208: LESS THAN ONE HOUR), the driving determination unit 74 determines whether the motor 31 is in the driven state (S209). When it is determined that the motor 31 is in the idle state (S209: IDLE STATE), the processes 100 end. That is, when the motor 31 enters the idle state within one hour from the start of driving and the state of the motor 31 is considered not to have a large change, the processes 100 end without the motor-related information D1 being written to the flash memory 52. As a result, it is possible to prevent an unnecessary increase in the number of writes to the flash memory 52.

On the other hand, when it is determined in the process S209 that the motor 31 is in the driven state (S209: DRIVEN STATE), the process S208 described above is executed. When one hour or more has elapsed since the start of driving of the motor 31 (S208: ONE HOUR OR MORE), the calculation unit 75 calculates various types of information on the driving current Id, the torque T, and the temperature Tm (S210). Note that the average, variance, minimum, and maximum of each of the driving current Id and the like calculated in the process S210 are values in a period of one hour from the start of driving of the motor 31.

The acquisition unit 76 acquires information indicating a calculation result in a period of one hour from the start of driving and the driving time (one hour) from the start of driving of the motor 31 as motor-related information Dn (n = 2) (S211). When the motor-related information D2 is acquired, the first writing unit 77 specifies a new storage area in the RAM 51 and writes the motor-related information D2 to the new storage area (S212).

The time determination unit 73 determines whether a driving time of one hour or more has elapsed since writing information to the new storage area in the RAM 51 (S213). When less than one hour has elapsed since writing information to the new storage area (S213: LESS THAN ONE HOUR), the driving determination unit 74 determines whether the motor 31 is in the driven state (S214). When it is determined in the process S214 that the motor 31 is in the driven state (S214: DRIVEN STATE), the process S213 is executed. As a result, each time a state in which the motor 31 is driven continues for one hour or more, new motor-related information Dn (n ≥ 3) is acquired by the acquisition unit 76 and written to a new storage area in the RAM 51 (S210 to S213). On the other hand, when it is determined in the process S214 that the motor 31 is in the idle state (S215: IDLE STATE), the second writing unit 78 acquires the motor-related information D stored in the RAM 51 and writes the motor-related information D to the flash memory 52 (S215). Therefore, the user can refer to the motor-related information D stored in the flash memory 52 as appropriate to grasp the operational state of the motor 31 and obtain knowledge about reliability and the like.

The robot control system 10 of this embodiment has been described above. During the motor 31 being driven, various types of arithmetic processes are executed in the microcomputer 62 to servo-control the motor 31. When the microcomputer 62 writes the motor-related information D to the flash memory 52 in addition to executing various types of arithmetic processes, the load of the arithmetic processes is further placed on the microcomputer 62, thus requiring the use of an expensive microcomputer. However, the second writing unit 78 of the microcomputer 62 writes the motor-related information D to the flash memory 52 in the idle state, in which the driving of the motor 31 is stopped (e.g., the process S215). Therefore, in this embodiment, it is not necessary to use a microcomputer having higher processing capability than necessary. Accordingly, in this embodiment, it is possible to reliably write the motor-related information D to the flash memory 52 while using an inexpensive microcomputer.

When the motor 31 is driven continuously, the acquisition unit 76 acquires the motor-related information D every one hour (the predetermined time period), which is an example of a time period suitable for observing a change in the state of the motor 31 (e.g., the processes S210 to S213). Therefore, the user can reliably grasp a change in the state of the motor 31.

The transmission unit 79 of the microcomputer 62 transmits the motor-related information D stored in the flash memory 52 to the control module 20 in accordance with the transmission instruction from the control module 20. Therefore, even when the motor module 23 is incorporated into the arm-type robot X and it is difficult for the user to access the motor module 23, the user can acquire the motor-related information D by using the control module 20 that is operated by the user.

The motor-related information D in this embodiment includes information indicating the driving time of the motor 31, the average, variance, minimum, and maximum of the driving current Id in the predetermined time period, the average, variance, minimum, and maximum of the torque T of the motor 31 in the predetermined time period, and the average, variance, minimum, and maximum of the temperature Tm in the predetermined time period. Since the motor-related information D includes such information, the user can obtain knowledge about the reliability or the like of the motor 31.

The user can also grasp the state of the motor 31 by acquiring all the data of the driving current Id while the motor 31 is driven. However, since the amount of data of the driving current Id increases while the motor 31 is driven, storing all the data of the driving current Id in the flash memory 52 also increases the storage area needed in the flash memory 52, and thus the load on the microcomputer 62 increases. In this embodiment, the average and the like of each of the driving current Id and the torque T are calculated in accordance with the driving current Id, and the motor-related information D including a calculated result is written to the flash memory 52. Accordingly, it is possible to reduce the storage area needed in the flash memory 52 and to reduce the load on the microcomputer 62.

The acquisition unit 76 is configured to acquire the motor-related information D every one hour in this embodiment, but the configuration is not limited thereto. For example, the acquisition unit 76 may be configured to acquire the motor-related information D in accordance with an acquisition instruction from the control module 20. That is, the acquisition unit 76 may be configured to acquire the motor-related information D in accordance with an acquisition instruction from the control apparatus for controlling the motor-related information processing circuit.

In such a case, the motor-related information D can be acquired at a desired timing specified by the user.

Note that the above example is for facilitating the understanding of the present invention, rather than for construing the present invention in a limited manner. The present invention may be modified or improved without departing from its gist, and equivalents thereof are also included in the present invention.

For example, it is assumed in Figs. 4 and 5 that the calculation process of the motor-related information D is executed at the timing of the process S205 and at the timing of the process S210, but the configuration is not limited thereto. Instead of the process S205, for example, the calculation unit 75 may execute the calculation process of the motor-related information D at a timing less than 10 minutes after the start of time measurement (the process S202). Instead of the process S210, the calculation unit 75 may execute the calculation process of the motor-related information D even when the driving time is less than one hour (the process S208: LESS THAN ONE HOUR). The calculation process is not limited to the order of flow illustrated in Figs. 4 and 5, and an example is also possible in which the calculation unit 76 performs cumulative calculation for calculating the maximum, minimum, and average when the driving circuit control unit 71 performs circuit control.

For example, the rotary encoder 32 has been described to output a signal indicating the rotational position of the rotor (not shown) in the motor 31 and a signal indicating the rotational speed of the motor 31, but the configuration is not limited thereto. A signal indicating the rotational position or the rotational speed of the motor 31 can be obtained by a magnetic detection sensor such as a Hall element instead of the rotary encoder 32. Alternatively, a signal indicating the rotational position or the rotational speed may be obtained in accordance with the driving current Id.

For example, the calculation unit 75 in the motor module 23 calculates the average and the like of the temperature Tm in accordance with output from the temperature sensor 33, but the configuration is not limited thereto. The calculation unit 75 may calculate information on the temperature of the motor 31 from the magnitude of the driving current Id, experimental data obtained in advance, or the like.

It is assumed that the motor-related information D includes various types of information such as the torque T of the motor 31 without being limited to information on the driving current Id, but the configuration is not limited thereto. The motor-related information D may include only, for example, information on the driving current Id. That is, the motor-related information D includes at least any one piece of information among information on the driving time of the motor, information on the driving current of the motor, information on the torque of the motor, and information on the temperature of the motor.

For example, the calculation unit 75 may perform a calculation for Fourier-transforming sound or noise information in accordance with output from a microphone for sensing ambient sound or noise. Thus, for example, the motor-related information D may include the frequency spectrum of ambient sound or noise.

For example, when the flash memory 52 stores the number of writes thereto (the number of update times), the transmission unit 79 may transmit the number of update times to the control module 20 in addition to the motor-related information D. The user can evaluate not only the reliability of the motor 31 but also the reliability (durability) of the flash memory 52 by grasping the number of update times of the flash memory 52.

Although it is assumed that the motor modules 23 to 25 are used for the arm-type robot X, such modules may be used for other applications. Specifically, for example, the motor modules 23 to 25 may be used to rotate various motors of automated guided vehicles, drones, common home appliances such as washing machines and vacuum cleaners, and the like.

Although it is assumed that the control information in this embodiment is the driving current Id or output of the rotary encoder 32 or the like, the control information is not limited thereto. For example, when the control of the motor is position sensorless vector control, an estimated value from the driving current Id or the like may be included. The control information may include not only output of the rotary encoder 32, but also information obtained by processing the output of the rotary encoder 32 (e.g., speed information obtained by differentiating the positional information).

This embodiment has described an example of writing the motor-related information D to the flash memory 52 in the idle state in which the driving of the motor is stopped. In this embodiment, this is realized by periodical writing to the flash memory 52. Here, it is conceivable that the control module 20 (control apparatus) makes a transition from the idle state to a shutdown state. The shutdown state is a state of performing a process in preparation for stopping power supply. When the control module 20 (control apparatus) makes a transition to the shutdown state, the control module 20 (control apparatus) transmits a shutdown instruction to the microcomputer 62. The microcomputer 62 may write the motor-related information D recorded in the RAM 51 to the flash memory 52 in accordance with the shutdown instruction. That is, the acquisition unit 76 may be configured to acquire the motor-related information D in accordance with the shutdown instruction from the control module 20. That is, the acquisition unit 76 may be configured to acquire the motor-related information D in accordance with the shutdown instruction from the control apparatus for controlling the motor-related information processing circuit.

It is also conceivable that power supply from outside the motor module 23 may be stopped for any reason. To enable writing to the flash memory 52 in such a state, the driving circuit 63 may be provided with a power storage unit (not shown). The power storage unit is, for example, a capacitor or a battery. The power storage unit stores power supplied from the robot control system 10. Stopping power supply from outside the motor module 23 is detected to write data to the flash memory 52.

### Reference Signs List

10 Robot control system, 20 Control module, 21, 22 Sensor module, 23 to 25 Motor module, 30 Motor control apparatus, 31 Motor, 32 Rotary encoder, 33 Temperature sensor, 50 ROM, 51 RAM, 52 Flash memory, 60, 61 IF circuit, 62 Microcomputer, 63 Driving circuit, 70 Setting unit, 71 Driving circuit control unit, 72 Time measurement unit, 73 Time determination unit, 74 Driving determination unit, 75 Calculation unit, 76 Acquisition unit, 77 First writing unit, 78 Second writing unit, 79 Transmission unit

## Claims

1. A motor-related information processing circuit comprising:
an acquisition unit configured to acquire motor-related information regarding an operational state of a motor when the motor is driven;
a first writing unit configured to write the motor-related information to a volatile memory after the motor-related information is acquired; and
a second writing unit configured to write the motor-related information stored in the volatile memory to a non-volatile memory when driving of the motor is stopped.

2. The motor-related information processing circuit according to claim 1, wherein
the acquisition unit acquires the motor-related information at predetermined time intervals.

3. The motor-related information processing circuit according to claim 1, further comprising
a transmission unit configured to, in accordance with a transmission instruction from a control apparatus for controlling the motor-related information processing circuit, transmit the motor-related information stored in the non-volatile memory to the control apparatus.

4. The motor-related information processing circuit according to claim 1, wherein
the motor-related information includes at least any one piece of information among information on a driving time of the motor, information on driving current of the motor, information on torque of the motor, and information on temperature of the motor.

5. The motor-related information processing circuit according to claim 4, further comprising
a calculation unit configured to perform a predetermined calculation process on the driving current of the motor, wherein
the acquisition unit acquires, as the motor-related information, a calculation result calculated by the calculation unit.

6. The motor-related information processing circuit according to claim 1, wherein
the acquisition unit acquires the motor-related information in accordance with an acquisition instruction from a control apparatus for controlling the motor-related information processing circuit.

7. The motor-related information processing circuit according to claim 1, wherein
the acquisition unit acquires the motor-related information in accordance with a shutdown instruction from a control apparatus for controlling the motor-related information processing circuit.

8. A motor-related information processing method comprising:
acquiring motor-related information regarding an operational state of a motor when the motor is driven;
writing the motor-related information to a volatile memory after the motor-related information is acquired; and
writing the motor-related information stored in the volatile memory to a non-volatile memory when driving of the motor is stopped.

9. A motor module comprising:
a motor;
a driving circuit configured to drive the motor; and
a motor-related information processing circuit including an acquisition unit configured to acquire motor-related information regarding an operational state of the motor when the motor is driven, a first writing unit configured to write the motor-related information to a volatile memory after the motor-related information is acquired, and a second writing unit configured to write the motor-related information stored in the volatile memory to a non-volatile memory when driving of the motor is stopped.

10. The motor module according to claim 9, wherein
the driving circuit comprises a power storage unit.
